# EUROPÄISCHE PATENTSCHRIFT

(11) **EP 2 804 061 B1**
(45) Veröffentlichungstag und Bekanntmachung des Hinweises auf die Patenterteilung: **09.09.2020**
(21) Anmeldenummer: 13168070.4
(22) Anmeldetag: 16.05.2013
(51) Int. Cl.: G05B 19/418

(54) **Verfahren zum Überwachen einer Prozess- und/oder Fertigungsanlage**
Method for monitoring a process and/or production plant
Procédé de surveillance d'une installation de processus et/ou de fabrication

(43) Veröffentlichungstag der Anmeldung: 19.11.2014
(73) Patentinhaber: Siemens Aktiengesellschaft, 80333 München (DE)
(72) Erfinder: Dallmann, Michael, 90530 Wendelstein (DE); Elger, Jürgen, 90602 Pyrbaum (DE); Gast, Christiane, 90455 Nürnberg (DE); Remmel, Markus, 76199 Karlsruhe (DE); Trenner, Thomas, 90766 Fürth (DE)

(56) Entgegenhaltungen:
- EP-A1- 1 699 005
- WO-A1-2006/051076
- DE-A1- 10 111 537
- DE-A1-102011 082 838

## Beschreibung

Die vorliegende Erfindung betrifft ein Verfahren zum Überwachen einer Prozess- und/oder Fertigungsanlage, die eine Mehrzahl von Komponenten umfasst und die mittels einer Mehrzahl von Engineeringsystemen geplant wird. Zudem betrifft die vorliegende Erfindung eine Vorrichtung zum Überwachen einer Prozess- und/oder Fertigungsanlage.

Es bestehen zurzeit erhebliche Defizite, Informationen über eine Anlage systemübergreifend aufzubereiten. Eine einheitlich vorliegende und elektronisch auswertbare "as-built"-Anlagendokumentation ist immer noch nur in Ausnahmefällen zu erreichen. Dies gilt insbesondere dann, wenn Zulieferer beteiligt sind, z.B. in der Distribution oder bei der Verkehrstechnik. Aufgrund der Heterogenität der Systemlandschaft im Engineering sind die von ihnen erzeugten Dokumente, Daten und Programme heute nicht automatisiert in Bezug setzbar - dies muss mit hohem Aufwand manuell durchgeführt werden. Damit ist nicht nur die Aufbereitung der Daten ein Problem, sondern insbesondere die Sicherstellung der Aktualität und Konsistenz, da dafür keine einheitlichen Mechanismen zur Verfügung stehen.

Es fehlen nicht nur Produkte am Markt, mit denen aus einem Engineeringprozess heraus die Ergebnisse verwaltet und aktuell gehalten werden können, es fehlen sogar konzeptionelle Grundlagen dafür. Beispiele hierfür sind die Sicherstellung der Konsistenz, die Integration der Stakeholder, die Verfolgung von Änderungen auf der Anlage durch Wartungs- und Instandhaltungsarbeiten, die einheitliche Versionsführungen von "as-built"-Ständen und dergleichen. Gelingt es, diese Problematik mit einem geeigneten Ansatz zu losen - und dazu die vorhandenen Produktpaletten einzubinden - könnte für die Kunden ein deutlicher Mehrwert generiert werden. Diese Problematik stellt sich insbesondere für die Betriebsführungsphase, also für Service- und Wartungsaktivitäten, aber auch zur Ursachenanalyse.

Heutige Systeme zur Diagnose oder zur Visualisierung von Prozessdaten, die auch als SCADA-Systeme (SCADA - Supervisory Control and Data Acquisition) bezeichnet werden, haben in der Regel keine Kenntnisse der Anlage selbst. Wenn derartige Zusammenhänge notwendig sind, müssen sie in den jeweiligen Systemen ausprogrammiert werden. Ein Beispiel hierfür ist die Erkennung von Leckagen in Druckluftleitungen, bei der üblicherweise an der Sensorik gespart wird, um Leckagen genauer einzugrenzen. Stattdessen werden Meldungen der Erzeuger und Verbraucher ausgewertet und anhand dessen versucht, Rückschlüsse über das System zu gewinnen. Zurzeit muss dazu die Topologie in Form von Programmen hinterlegt werden, was dazu führt, dass bei Änderungen der Anlage die Programme zu analysieren und zu überarbeiten sind. Wenn dagegen die Topologie der Anlage auswertbar vor Ort zur Verfügung steht, kann man die entsprechenden Leitungen traversieren und Erzeuger und Verbraucher in Bezug setzen, so dass eine generische Diagnose möglich wird.

Klassischerweise werden Daten zwischen den Engineeringsystemen über Import- und Exportvorgänge ausgetauscht und jedes System für sich erstellt einen Teil der Anlagendokumentation. Aktualität und Konsistenz der Dokumentation ist manuell sicherzustellen, zumal es bei den meisten Werkzeugen im Anlagenbau kein Versionsmanagement gibt. Die Dokumentation liegt (mit Ausnahme der Automatisierungs- und Leittechniksoftware) in der Regel als PDF- oder TIFF-Dokument vor und ist nicht weiter auswertbar. Für die Betriebsführung selber werden in der Regel Einzelsysteme angeboten wie z.B. MRO-Systeme (MRO - Maintenance, Repair and Overhaul) oder Diagnosesysteme. Sie müssen üblicherweise Dokumente und/oder Daten der Engineeringsysteme importieren. Damit liegt aber kein applikations- oder gewerkeübergreifendes Modell vor. Zudem ist die Topologie aus diesen Daten und Dokumenten nicht ableitbar.

Dokumentenmanagementsysteme (DMS-Systeme) bauen wiederum auf der Dokumentation der Engineeringsysteme auf. Diese unterstützen auch eine Versionsführung der Dokumente. Teilweise gibt es Systeme, die im Nachhinein Dokumente scannen und anhand der Kennzeichnung Verlinkungen auf Dokumentenebene aufbauen (z.B. zum Aufbau eines elektronischen Teilekatalogs). Hierbei werden zusätzlich Versionsangaben, Freigabe oder dergleichen zusätzlich zum Dokument gespeichert. Die Topologie einer Anlage ist für ein DMS-System aber ebenfalls nicht maschinell auswertbar.

Produktdatenmanagementsysteme (PDM) wiederum sehen das Engineeringsystem als eine zentrale Informationsdrehscheibe, d.h. als Dokumentation werden hierbei die Originalsysteme verwendet. Im Regelfall weisen Systeme für die Erzeugung von Produkten auch eine Versionsführung auf. Hierbei werden CAD-Daten (CAD - Computer Aided Design) und ERP-Daten (ERP - Enterprise-Resource-Planning) erfasst. Es gibt Ansätze, dieses Verfahren auf den Anlagenbau zu übertragen, d.h. die Engineeringsysteme und -daten an den Betreiber der Anlage mit auszuliefern und sie in die Betriebsführung einzubeziehen, was beispielsweise mit einem PDM-System nicht möglich ist.

Bei dem Engineeringsystem COMOS verwendet das MRO-System direkt die Original-Engineeringdaten, es stellt quasi eine funktionale Erweiterung des CAE-Systems (CAE - Computer Aided Engineering) dar. Dieses Werkzeug ist aber nur für die Prozessindustrie gedacht. Für die Fertigungsindustrie, in der traditionell sehr viele Zulieferer eingebunden sind, sind derartige Werkzeuge nicht bekannt. Nachteil des Ansatzes ist, dass ein derartiges Engineeringwerkzeug nicht gleichermaßen für die Betriebsführung sowie für das Engineering optimiert sein kann. Ein Know-How-Schutz ist ebenfalls nur schwierig zu realisieren. Ferner kann es nur die Daten als Abbild bereitstellen, die es in dem eigenen Engineeringwerkzeug integriert hat. Daten von Fremdsystemen müssen manuell importiert und an das Datenmodell adaptiert werden, was die Aktualität und Konsistenzhaltung erschwert. Ein weiteres Problem ist die Notwendigkeit, verschiedene Aufgabenstellung im Anlagenbau durch ein solches Werkzeug zu realisieren. Im Regelfall ist dies ein sehr teurer und riskanter Weg, da heterogene Engineeringsysteme mit ihrem kompletten Funktionsumfang, der in der Regel über Jahre entstanden ist, auf eine gemeinsame Plattform zu bringen sind. In der Vergangenheit sind mehrere solche Entwicklungen gescheitert, da sie aufgrund der Laufzeit des Entwicklungsvorhabens die bestehenden Engineeringsysteme für Kunden ebenfalls funktional erweitern mussten und damit die Umsetzung des neuen Systems immer schwieriger und teurer wurde. In vielen Fällen sind solche Plattformansätze auch nicht mehr "best of breed" und eine Reihe von Kunden möchte sich auch nicht von einem Zulieferer allein abhängig machen.

Es gibt ferner den Ansatz, zugrundeliegende Modelle zu standardisieren und Produkte zu diesem Standard kompatibel zu machen, so dass zumindest ein durchgängiger Austausch von Daten möglich wird (z.B. mit dem Programm STEP). Auch hier sind viele Bemühungen steckengeblieben, nicht zuletzt deswegen, weil die Hersteller von Engineeringwerkzeugen nicht austauschbar sein wollen. Generell ist aber festzuhalten, dass diese Modelle primär das Zusammenspiel der Engineeringwerkzeuge im Fokus haben und nicht die Optimierung der Betriebsführung. Die internationale Patentanmeldung WO2006/051076-A1 offenbart ein Verfahren zur Verknüpfung von technischen Daten und ein System zum Bedienen und Beobachten einer industriellen Anlage. Hierbei werden Daten zur Dokumentation der Anlage mittels eines Dokumentationsgenerators in mindestens ein standardisiertes Format überführt und dann nach semantischen Gesichtspunkten verknüpft.

Es ist Aufgabe der vorliegenden Erfindung, einen Weg aufzuzeigen, wie eine Prozess- und/oder Fertigungsanlage einfacher und effizienter überwacht werden kann.

Diese Aufgabe wird durch ein Verfahren mit den Merkmalen des Patentanspruchs 1 gelöst. Vorteilhafte Weiterbildungen der Erfindung sind Gegenstand der Unteransprüche.

Das erfindungsgemäße Verfahren zum Überwachen einer Prozess- und/oder Fertigungsanlage, die eine Mehrzahl von Komponenten umfasst und die mittels einer Mehrzahl von Engineeringsystemen geplant wird, umfasst das Bereitstellen von ersten Ergebnisdaten zu zumindest einem Teil der Komponenten mit einem ersten der Engineeringsysteme, das Bereitstellen von zweiten Ergebnisdaten zu zumindest einem Teil der Komponenten mit einem zweiten der Engineeringsysteme, das Extrahieren von Topologiedaten, die eine Anordnung der Komponenten innerhalb der Prozess- und/oder Automatisierungsanlage beschreiben, und Betriebsdaten der Komponenten aus den ersten und zweiten Ergebnisdaten, und das Erstellen eines Modells für die Prozess- und/oder Fertigungsanlage anhand der Topologiedaten und der Betriebsdaten.

Die Engineeringsysteme stellen unterschiedliche Werkzeuge zum Planen und Erstellen der Prozess- und/oder Fertigungsanlage bereit. Diese können beispielsweise durch ein jeweiliges Programm bereitgestellt werden. Die Engineeringsysteme können durch eine CAE-Applikation bereitgestellt werden, die jeweils unterschiedliche technische Aspekte der Anlage betreffen. Von den Engineeringsystemen werden jeweils Ergebnisdaten bereitgestellt. Dabei können Prinzipien aufgegriffen werden, die bei CAE-Systemen für Revisionen verwendet werden. Sie stellen - vereinfacht dargestellt - Sichten oder Reports auf die Daten dar, die inhaltlich geprüft und dann festgehalten wurden. Sie dienen zur gezielten Weitergabe von Ergebnisdaten. Damit kann mit diesen Ergebnisdaten ein Abbild des Engineeringprozesses von dem jeweiligem Engineeringsystem bereitgestellt werden. Dieses Abbild stellt zunächst einen Planungsstand der Anlage dar und ist zu unterscheiden von Ständen, die tatsächlich auf der Anlage umgesetzt sind bzw. verwendet werden. Werden diese Abbilder einheitlich geführt, kann ein Versionsmanagement aufgesetzt werden, mit dem diese Stände unterscheidbar werden. Dabei können die Ergebnisdaten in der Reihenfolge des Engineeringprozesses zur Planung der Anlage bereitgestellt werden. Die Ergebnisdaten können in einer datenverarbeitungstechnisch auswertbaren Form bereitgestellt werden. Beispielsweise können die Ergebnisdaten im XML-Format bereitgestellt werden. Die Verwendung der Ergebnisdaten vereinfacht die Betrachtung der Daten, da diese Daten i.d.R. nicht mehr direkt auf der internen Datenhaltung der Engineeringsysteme basieren, sondern eine standardisiertere Sicht darauf verwenden(z.B. in Form von Stromlauf- oder Klemmenplänen) .

Aus den Ergebnisdaten der zumindest zwei Engineeringssysteme werden Topologiedaten extrahiert, die die Wirkverbindung der Komponenten der Anlage beschreiben. Zudem werden Betriebsdaten der Komponenten der Anlage extrahiert. Aus den Topologiedaten und kann ein Modell bzw. ein digitales Abbild der Anlage sukzessive erstellt werden und mit den den aktuelle Prozessdaten der Anlage in Bezug gesetzt werden. Dabei können die Topologiedaten und die Betriebsdaten auch mit einem Know-How-Schutz versehen werden. Damit kann zusätzlich verhindert werden, dass Dritten, wie beispielsweise Zulieferern, kein Zugriff auf die Daten ermöglicht wird. Durch die Verwendung der Ergebnisdaten statt der Originaldaten der Engineeringwerkzeuge ist implizit bereits ein Know How Schutz gegeben, da die Daten des Abbildes in der Regel nicht ausreichen, um ein Engineering der Anlage durchzuführen.

Ein solches Modell kann für eine Optimierung der Betriebsführung genutzt werden. Mittel- bis langfristig kann ein solches Abbild zu einem Zusammenwachsen der zugrundeliegenden Engineeringapplikationen führen. Es kann nicht nur dazu führen, dass einheitliche Reportsysteme entstehen, sondern dass Eigenschaften eines solchen Abbildes sukzessive in die Entwicklung der Applikationen einfließen, ohne dass die Applikationen ihre Eigenständigkeit aufgeben müssen.

Bevorzugt werden in einer Darstellung des Modells die Anordnung der Komponenten innerhalb der Prozess- und/oder Automatisierungsanlage und die Betriebsdaten zu den jeweiligen Komponenten angezeigt. Im Freigabeprozess in den jeweiligen Engineeringsystemen können die Ergebnisdaten in Form einer Vektorgaphik und einem zugehörigen Metamodell ausgegeben werden. Die Darstellung des Modells kann dabei so aufgebaut sein, dass die Komponenten der Anlage als Objekt in der Darstellung erkennbar und selektierbar sind. Zudem kann ein Bezug zwischen dem graphischen Element und dem Metamodell, in dem beispielsweise die Betriebsdaten der Komponente hinterlegt sind, hergestellt werden.

In einer Ausführungsform werden bei den Topologiedaten eine jeweilige eingangsseitige und ausgangseitige Wirkverbindung der Komponenten untereinander extrahiert. Damit können die Verbindungen der einzelnen Komponenten in der Anlage einfach erfasst werden und auf zuverlässige Weise ein Modell bzw. Abbild der Anlage bereitgestellt werden.

In einer weiteren Ausgestaltung werden als erste oder zweite Ergebnisdaten von den Engineeringsystemen ein dreidimensionales Modell, ein Rohrleitungsplan und/oder ein Stromführungsplan bereitgestellt. Die Engineeringssysteme zum Planen der Anlage können unterschiedliche technische Bereiche betreffen. Dabei können ausschließlich die Ergebnisse der Engineeringsysteme mittels der Ergebnisdateien verwendet werden. Somit werden nur die für den Betrieb der Anlage relevanten Daten zur Erstellung des digitalen Modells für die Anlage verwendet werden.

Bevorzugt werden als erste oder zweite Ergebnisdaten von den Engineeringsystemen Datenblätter und/oder Betriebsparameter der Komponenten bereitgestellt. Somit können zusätzlich Betriebsgrößen der jeweiligen Komponenten, die in der Anlage verwendet werden, in das Modell integriert werden. Damit können beispielsweise Engineeringobjekte wie Motoren oder Pumpen mit Prozessdaten wie Betriebsstundenzählern oder Alarmen kombiniert werden. Während Engineeringsysteme bezüglich der Ablage und des Handlings optimiert für die Projektierung von Anlagen sein können, kann das Abbild für die Betriebsführungsphase ausgelegt sein.

In einer weiteren Ausführungsform werden die aus den ersten und zweiten Ergebnisdaten extrahierten Topologiedaten und Betriebsdaten in ein vorbestimmtes Datenformat überführt. Die Ergebnisdaten können in einer einheitlichen Form geführt werden, so dass generische Funktionen zum Suchen und Traversieren von Daten möglich sind. Damit können Service- und Diagnoseapplikationen einheitlich verwendet werden.

Bevorzugt werden den Topologiedaten und Betriebsdaten zusätzlich Herkunftsdaten zugeordnet, die beschreiben, ob die Topologiedaten und Betriebsdaten von dem ersten oder dem zweiten Ergebnisdaten extrahiert sind. Auf diese Weise kann eine Herkunftsfunktion bereitgestellt werden, mit der nachverfolgt werden kann, von welcher Ergebnisdatei bzw. von welchem Engineeringsystem Daten stammen.

Bevorzugt wird in dem Modell eine Verknüpfung zu den ersten und den zweiten Ergebnisdaten bereitgestellt. Damit kann eine Möglichkeit bereitgestellt werden, von dem digitalen Abbild in das zugrundeliegende Engineeringsystem unter Berücksichtigung des Objektbezugs zu wechseln. Wenn beispielsweise eine Komponente in der graphischen Darstellung eines Rohrleitungsplans selektiert, kann ein Wechsel in die zugehörige CAE-Applikation, in der der Rohrleitungsplan entstanden ist, möglich sein. Voraussetzung dafür ist natürlich, dass auf der Anlage diese Applikationen
zur Verfügung stehen.

In einer weiteren Ausgestaltung wird bei einer Änderung der ersten und/oder zweiten Ergebnisdaten das Modell angepasst. Damit können Daten unterschiedlicher Applikationen oder Gewerke integriert werden, ohne dass komplette Neuimplementierungen bei den Engineering- und/oder Laufzeitsystemen notwendig sind.

Bevorzugt werden die Änderung der ersten und/oder zweiten Ergebnisdaten in dem Modell angezeigt. Generell kann eine Versionsführung der Daten unterstützt werden, auch wenn die Engineeringsysteme dies nicht leisten. Der Aufbau des Modells sollte in den Engineeringprozess so integriert werden, dass es aktuell und konsistent gehalten wird. Änderungen an der Anlage - am Engineeringprozess vorbei - können dabei erfassbar sein und den zugehörigen Engineeringsystemen übergeben werden können. Des Weiteren können Service- und Wartungstechniker mit dem Modell der Anlage nahtlos umgehen können. Dies bedeutet insbesondere, dass die bisher verwendeten Reports bezüglich ihrer Darstellung und Inhalte in einer analogen Form zur Verfügung gestellt werden können.

Die erfindungsgemäße Vorrichtung zum Überwachen einer Prozess- und/oder Fertigungsanlage, die eine Mehrzahl von Komponenten umfasst und die mittels einer Mehrzahl von Engineeringsystemen geplant ist, umfasst eine Empfangseinrichtung zum Empfangen von ersten Ergebnisdaten zu zumindest einem Teil der Komponenten von einem ersten der Engineeringsysteme und zum Empfangen von zweiten Ergebnisdaten zu zumindest einem Teil der Komponenten von einem zweiten der Engineeringsysteme, und eine Recheneinrichtung zum Extrahieren von Topologiedaten, die eine Anordnung der Komponenten innerhalb der Prozess- und/oder Automatisierungsanlage beschreiben, und Betriebsdaten der Komponenten, aus den ersten und zweiten Ergebnisdaten und zum Erstellen eines Modells für die Prozess- und/oder Fertigungsanlage anhand der Topologiedaten und der Betriebsdaten.

Die im Zusammenhang mit dem erfindungsgemäßen Verfahren beschriebenen Weiterbildungen können auf die erfindungsgemäße Vorrichtung übertragen werden.

Die vorliegende Erfindung wird nun anhand der beigefügten Zeichnungen näher erläutert. Dabei zeigen:
- FIG 1: eine schematische Darstellung einer Vorrichtung zum Überprüfen einer Prozess- und/oder Fertigungsanlage;
- FIG 2: eine Darstellung eines Modells der Prozess- und/oder Fertigungsanlage;
- FIG 3: eine schematische Darstellung eines Demonstrators; und
- FIG 4: eine schematische Darstellung der Vorrichtung zum Überprüfen einer Prozess- und/oder Fertigungsanlage in einer weiteren Ausführungsform.

Die nachfolgend näher geschilderten Ausführungsformen stellen bevorzugte Ausführungsformen der vorliegenden Erfindung dar.

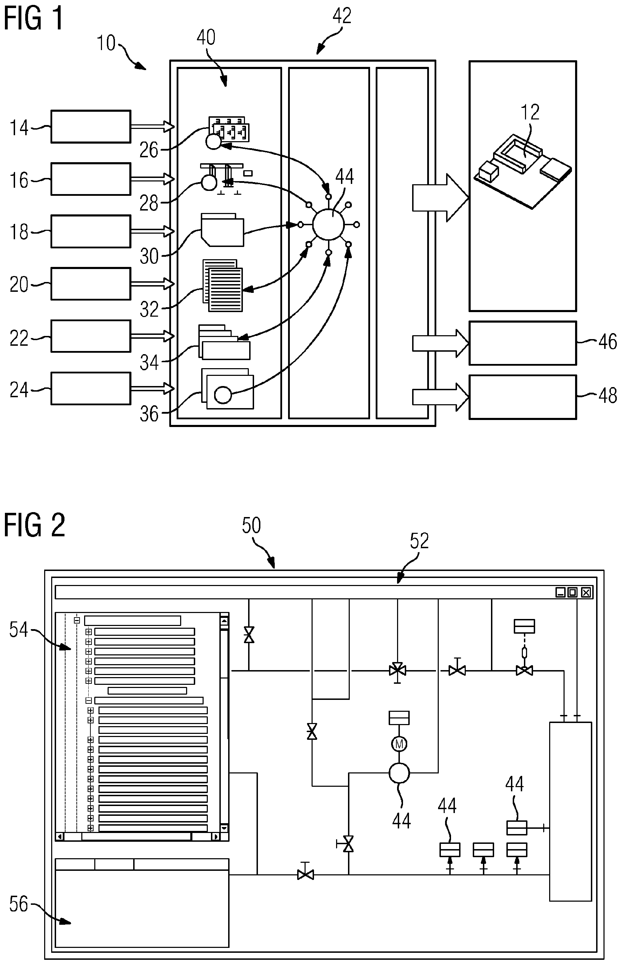

FIG 1 zeigt eine schematische Darstellung einer Vorrichtung 10 zum Überprüfen einer Prozess- und/oder Fertigungsanlage 12. Die Prozess- und/oder Fertigungsanlage 12 wird mit mehreren Engineeringssystemen geplant. Vorliegend wird die Anlage 12 mit sechs Engineeringssystemen 14, 16, 18, 20, 22, 24 geplant. Die Engineeringssysteme 14, 16, 18, 20, 22, 24 betreffen unterschiedliche technische Gebiete. Beispielsweise kann mit dem Engineeringssystem 14 ein Rohrleitungs- und Installationsplan bereitgestellt werden. Mit dem Engineeringssystem 16 kann ein Stromlaufplan bereitgestellt werden. Mit dem Engineeringssystem 18 kann ein dreidimensionaler Plan der Anlage 12 bereitgestellt werden. Mit dem Engineeringssystem 20 können Datenblätter zu den Komponenten 44 der Anlage 12 bereitgestellt werden. Mit dem Engineeringssystem 22 können Continuous Function Charts (CFC) für eine Speicherprogrammierbare Steuerung bereitgestellt werden. Schließlich kann mit dem Engineeringssystem 24 eine Prozessvisualisierung bereitgestellt werden.

Wenn die Planung der Anlage 12 mit dem jeweiligen Engineeringssystem 14, 16, 18, 20, 22, 24 abgeschlossen ist, werden von jedem der Engineeringssysteme 14, 16, 18, 20, 22, 24 zugehörige Ergebnisdaten 26, 28, 30, 32, 34, 36 ausgegeben. Diese Ergebnisdaten 26, 28, 30, 32, 34, 36 werden von einer Empfangseinrichtung 40 der Vorrichtung 10 empfangen. Mit einer Recheneinrichtung 42 der Vorrichtung 10 werden Topologiedaten, die eine Anordnung der Komponenten 44 innerhalb der Prozess- und/oder Fertigungsanlage 12 beschreiben, und Betriebsdaten der Komponenten 44 extrahiert. Aus den Topologiedaten und den Betriebsdaten werden mit der Recheneinrichtung 42 ein Modell bzw. digitales Abbild der Anlage 12 erstellt. Zudem weist die Vorrichtung 10 eine Benutzerschnittstelle 46 und eine Schnittstelle 48 zur Anbindung weiterer Dienste, die beispielsweise für Diagnosedienste oder für Service- und wartungsbezogene Aktivitäten verwendet werden können, auf.

Dadurch, dass die revisionierten Reports und Dokumente in Form der Ergebnisdaten 26, 28, 30, 32, 34, 36 entsprechend der Reihenfolge des Engineeringprozesses entstehen, kann davon ausgegangen werden, dass zentrale Bezugskomponenten zu Beginn definiert werden und später durch Informationen angereichert werden. Dieses Modell 50 wird dann bei der Bildung von Revisionsständen (bzw. bei der Freigabe von Unterlagen) implizit aktualisiert bzw. aufgebaut, so dass sich das Modell 50 nahtlos in den Engineeringprozess eingliedert. Es sind lediglich entsprechende Reports bzw. Revisionen so zu erweitern, dass die Ergebnisdaten 26, 28, 30, 32, 34, 36 in einem auswertbaren Format weitergegeben werden. Das Modell 50 unterstützt keine Engineeringfunktionalität, das Modell 50 ist aber für eine gewerke- und applikationsübergreifende Navigation optimiert. Ferner dient das Modell 50 als einheitliche Basis, um applikationsunabhängig den Planungsstand der Anlage mit dem des realen Standes zu vergleichen, Änderungen in den Engineeringdaten müssen über die Originalwerkzeuge erfolgen. Für die Hin- und Rückübertragung werden Verweise zu den Originaldaten und -Applikationen geführt (Herkunftsnachweis). Dadurch, dass die Daten einheitlich in einem Metamodell geführt werden, sind auch einheitliche Funktionen wie Querys, Reports, Versionsverwaltungen oder dergleichen realisierbar.

FIG 2 zeigt ein Modell 50 der Anlage 12 in der Darstellung in einem 2D-Viewer. In einem ersten Fenster 52 sind die einzelnen Komponenten 44 der Anlage 12 und deren Wirkverbindung (in diesem Fall ein Rohrleitungs- und Installationsdiagramm)grafisch dargestellt. In einem zweiten Fenster 54 sind die einzelnen Komponenten 44 aufgelistet. Hier können die Ergebnisdaten 26, 28, 30, 32, 34, 36 der Engineeringssysteme 14, 16, 18, 20, 22, 24 so dargestellt werden, dass die Verbindung zwischen dem Metamodell und der zugehörigen grafischen Darstellung verfolgt werden kann. Beispielsweise kann in dem zweiten Fenster 54 eine Komponente 44 in der Anlagenhierarchie selektiert werden und im dazugehörigen Rohrleitungs- und Instrumentierungsplan in dem ersten Fenster 52 hervorgehoben werden. In einem dritten Fenster 56 können zudem Betriebsgrößen der ausgewählten Komponente 44 angezeigt werden.

Durch die verschiedenen Revisionen bzw. Freigaben von Dokumenten und Daten im Engineeringprozess in Form der Ergebnisdaten 26, 28, 30, 32, 34, 36 entstehen sukzessive Teilabbilder der Anlage 12. Diese werden verwendet, um implizit das gewerkeübergreifende Modell 50 zu erweitern bzw. zu aktualisieren. Für das digitale Abbild werden diese Daten und Dokumente verbunden. Dadurch, dass nur freigegebene Dokumente und Daten verwendet werden, wird ferner erreicht, dass nur solche Informationen in das Modell 50 übernommen werden, die einen gewissen Reifegrad haben. Wenn Arbeitsstände zusammengeführt werden, ist zu befürchten, dass immer wieder zueinander inkonsistente Stände auftreten, die entsprechende Zusatzaufwände nach sich ziehen. Über den Engineeringprozess ist eine gewisse Reihenfolge vorgegeben, in der diese Dokumente und Daten entstehen. Beispielsweise wird zuerst ein Rohrleitungs- und Installationsplan (P&ID) erstellt, bevor Gerätespezifikationen zu den Komponenten 44 des Diagramms erfolgen. Die Spezifikationen werden dann mit den Komponenten 44 des Rohrleitungs- und Installationsdiagramms verlinkt.

Wesentlich ist, dass nicht Dokumente oder Pläne "an sich" verlinkt werden, sondern Objekte dieser Unterlagen. Beispielsweise muss es möglich sein, zu einer Pumpe in einem P&ID zugehörige weitere Dokumente wie Stromlaufpläne, oder Produktbeschreibungen des jeweiligen Herstellers zu erhalten, aber auch Daten wie Leistungsangaben und Grenzwerte. Die Objekte können verschiedenste - auch gewerkeübergreifende - Bezüge aufweisen, so z.B. ein Bezug zwischen der Pumpe und einem zugeordneten CFC-Plan. Das Abbild 50 muss dazu einen generischen (erweiterbaren) Charakter haben.

Als Grundlage dafür muss es gemeinsame Objektbegriffe (z.B. zu Anlagenobjekten) geben. Generell gilt, dass es innerhalb eines Projekts eindeutige Festlegungen geben muss, nach denen die Objekte, Pläne und Dokumente zusammenhangen (z.B. über das im Projekt verwendete Kennzeichnungssystem). Es wird deswegen die Annahme gemacht, dass derartige Beziehungen über Regeln automatisch generiert werden können, so dass keine zusätzliche Engineeringleistung für die Erzeugung des Modells 50 notwendig ist. Sollte trotzdem in bestimmten Fällen die zugrundeliegenden Informationen nicht ausreichen bzw. die daraus abzuleitenden Regeln zu kompliziert werden, sind in den Engineeringsystemen 14, 16, 18, 20, 22, 24 additive Daten zu führen.

Beispielsweise wird in einem CAE-System eine Füllstandmessung durch einen Dateinamen definiert. Im zugehörigen CFC ist stattdessen ein anderer Dateiname angegeben. Für eine generische Verlinkung sind diese Angaben zu normieren, es beispielsweise entsprechende Begriffe aus den Dateinamen zu extrahieren. Diese Art der Kennzeichnungen können von Projekt zu Projekt verschieden sein. Innerhalb eines Projektes liegen aber normalerweise einheitliche Konventionen vor, so dass entsprechende Automatismen ableitbar sind. Ansonsten ist auch die Dokumentation der Anlage nicht zusammenhängend.

Durch dieses Abbild 50 wird auf den ersten Blick eine doppelte Datenhaltung erzeugt. Sie liegt aber zurzeit ebenfalls vor, da zurzeit verwendeten Revisionsunterlagen nichts anderes als Abzüge der Daten aus den Engineeringsystemen 14, 16, 18, 20, 22, 24 darstellen. Wesentlich in dem Zusammenhang ist, dass das Modell 50 im Sinne eines Caches arbeitet und keine eigenständige Engineeringdatenhaltung bildet, die entsprechend abzugleichen wäre. Deswegen müssen applikationsübergreifende Beziehungen aufgrund vorhandener Informationen ableitbar sein.

Das Prinzip, die Ergebnisdaten 26, 28, 30, 32, 34, 36 der Engineeringsysteme 14, 16, 18, 20, 22, 24 in einem von den Applikationen separierten Abbild 50 zu halten, bedeutet, dass dieses Abbild 50 keine ständige Verbindung zu den Applikationen benötigt, die Schnittstelle weist eher den Charakter eines "loosely coupled systems" auf. Dies ist auch notwendig, da davon auszugehen ist, dass nicht alle Engineeringwerkzeuge vor Ort installiert und online zugreifbar sind. Bei Zulieferungen von Drittfirmen ist in der Regel kein Zugriff auf die Originalwerkzeuge gegeben, es werden aber die für die Inbetriebsetzung und den Betrieb benötigten Dokumente und Daten weitergegeben. Diese Informationen können nach dem gleichen Muster in das Abbild 50 integriert werden (evtl. mit einem eingeschränkten Funktionsumfang).

Der Ansatz, die aus den Applikationen erzeugten Ergebnisunterlagen (z.B. PDF-Dokumente und CAD-Zeichnungen) nachträglich im Sinne einer verlinkten elektronischen Dokumentation zusammenzuführen, ist bekannt. Bei diesen Systemen ergibt sich aber immer die Problematik, bereits erzeugte Dokumente nachträglich in eine derartig verlinkte Struktur zu überführen. Dies ist teilweise mit erheblichem Aufwand verbunden, da beispielsweise Kennzeichnungen in den Dokumenten erkannt und analysiert werden müssen (z.B. sind relative Pfadangaben zusammenzusetzen). Hersteller von Engineeringtools können diese Daten wesentlich einfacher zur Verfügung stellen, indem sie entsprechende Exportstrukturen zur Verfügung stellen. Dies ist auch ein wesentlicher Aspekt des Konzepts.

Das Prinzip, Ergebnisdaten in Form von revisionierten Reports weiterzugeben, wurde benötigt, da viele Engineeringsysteme 14, 16, 18, 20, 22, 24 (insbesondere CAE Systeme) keine echte Versionsführung von Daten aufweisen. Bei einem freigegeben Stand muss aber - neben einer dauerhaften Sicherung - eine Möglichkeit bestehen, im Nachhinein Änderungen zu diesem Stand kenntlich zu machen.

Ein weiterer Grund für die Erzeugung von Dokumenten ist der, dass eine Weitergabe von Daten an einen Kunden oder eine Drittfirma in der Regel nur dann möglich ist, wenn diese genau das gleiche Tool verwendet, da es kaum etablierte Standards für die Datenhaltung im Anlagenumfeld gibt. Durch die Dokumentform wird dieses Problem umgangen, zumal die Unterlagenarten (z.B. Stromlaufpläne) einen wesentlich besseren Standardisierungsgrad aufweisen.

Für das Modell 50 bzw. Abbild ergeben sich daraus folgende Konsequenzen: Im Moment können für eine Umsetzung von Engineeringdaten in eine Anlage 12 nur die Revisionen als Grundlage verwendet werden. Wenn Engineeringsysteme 14, 16, 18, 20, 22, 24 eine Versionsführung gestatten, können entsprechend gelabelte Stände der Werkzeuge als Grundlage verwendet werden. Aufgrund der zu verwaltenden Mengengerüste und der benötigten Flexibilität der Datenhaltung (in den Projekten sind unterschiedlichste Werkzeuge einzubinden) macht es aber Sinn, auch hier die Daten in ein separates Abbild zu überführen. Die Inhalte dieser Revisionen müssen einen auswertbaren Charakter erhalten, der applikations-übergreifend (zumindest an den Schnittstellen der Ergebnisdaten 26, 28, 30, 32, 34, 36) abzustimmen ist. Das Abbild 50 muss als Datenbasis für das Redlining fungieren, ansonsten würden Änderungen an der Anlage 12 nicht erfasst werden. Das Abbild 50 muss eine Möglichkeit bieten, Änderungen gegenüber freigegebenen Ständen der Applikationen auszuweisen.

Speziell die letztere Forderung ist gravierend. Nur ein separates Modell 50 ist in der Lage, gewerke- und applikationsübergreifend eine Versionsführung von Engineeringdaten (z.B. "as-built" Stände) zu bieten. Durch den Aufbau des Modells 50 können dazu Redlining Funktionen applikationsübergreifend einheitlich angeboten werden. Mit Hilfe des Herkunftsnachweises können diese Änderungen den Ursprungsapplikationen weitergegeben werden.

Die Daten der Applikationen müssen für das Metamodell des digitalen Abbilds 50 transformiert werden. Zwar erfolgt dieser Schritt nur bei einer Freigabe von Daten, bei großen Mengengerüsten kann dies aber dennoch zu Performanceproblemen führen. Für solche Fälle können die in Frage kommenden Applikationen eine Deltagenerierung unterstützen, um nur geänderte Teile weiterzugeben. Das Abbild 50 muss dann umgekehrt eine solche Deltaliste verarbeiten können.

Zeichnungen und Pläne, die aus den Engineeringsysteme 14, 16, 18, 20, 22, 24 übernommen werden, müssen zwar auswertbar sein (es müssen beispielsweise Objekte identifizierbar sein), sie stellen aber fertige Ergebnisse dar und müssen nicht aus einer komplexen Datenhaltung heraus aufgebaut werden. Nur so sind die Mengengerüste, die bei großen Anlagen auftreten (z.B. 13.000 Stromlauf- und Funktionsplane bei Gepäckförderanlagen) performant zu verwalten. Eine Navigation, die zur Selektion von Plänen und Daten ständig verschiedene umfangreiche Datenhaltungen durchsuchen muss, würde kaum für Service und Wartungszwecke akzeptiert werden.

Dadurch, dass alle Zeichnungen und Daten in einer einheitlichen Form vorliegen, können die so übernommenen Zeichnungen und Daten mit Prozessdaten der Anlage verknüpft werden. Beispielsweise ist es nun möglich, Diagnoseinformationen zu Komponenten wie Pumpen direkt in P&ID-Diagrammen einzublenden. Für den Wartungstechniker bedeutet dies, dass er einerseits mit den gewohnten Unterlagen weiterarbeiten kann, andererseits aber auch aktuelle Informationen von der Anlage erhalt, Es muss
lediglich mit Hilfe der Namensgebung der Objekte eine Verbindung zu den Daten der SCADA- oder Diagnose Systeme hergestellt werden.

Objekte und Dokumente müssen einen Herkunftsnachweis aufweisen. um Änderungen an die Originalwerkzeuge delegieren zu können. Daten und Unterlagen weisen immer eine Kennzeichnung auf, anhand derer sie eindeutig (innerhalb des vorliegenden Projektes) identifiziert werden können. Für die Anbindung an die Originalapplikationen muss diese Information aber um Angaben ergänzt werden, damit das zugrundeliegende Applikationsprojekt bzw. die Applikation selber identifiziert werden kann. Ein solcher Herkunftsnachweis ermöglicht eine Buchführung, welche Werkzeuge und Ablagen in dem vorliegenden Projekt verwendet wurden und wo sie zu finden sind. Ein Problem bei dem Ansatz ist die Eindeutigkeit der Zuordnung zu den Daten. Hierbei ist es nicht zu vermeiden, dass Daten in mehreren Engineeringwerkzeugen vorkommen und dort auch geändert werden können. Allein die Tatsache, dass es vielfach überlappende Informationen in den Werkzeugen gibt, führt dazu. Vorliegend wird aber davon ausgegangen, dass es Festlegungen gibt, wer für welche Daten verantwortlich ist. Diese Verantwortlichkeit muss sich dann auch in dem Herkunftsnachweis niederschlagen.

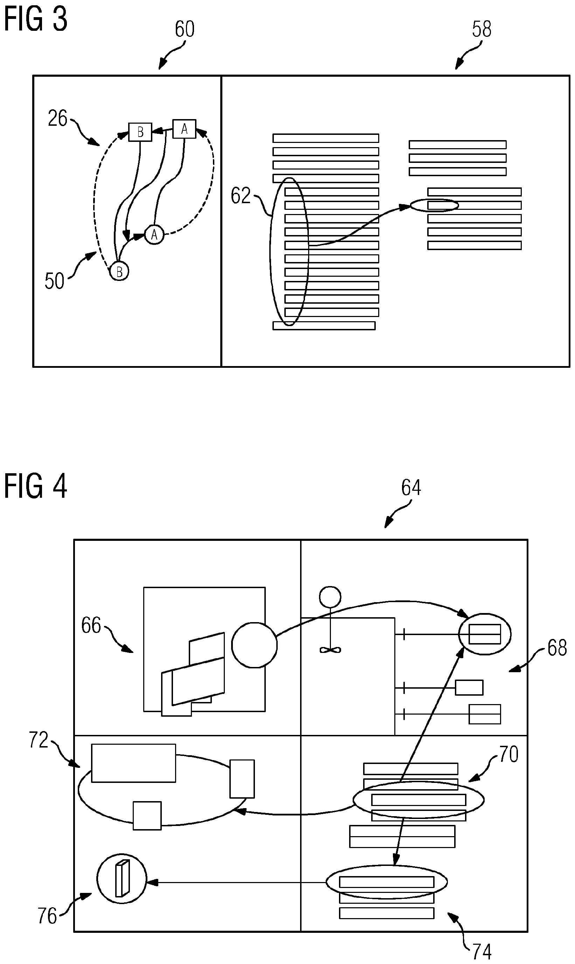

FIG 3 zeigt eine schematische Darstellung eines Demonstrators 58. Für einen Demonstrator 58 wurde das Engineeringsystem 14 COMOS V9.0 als Plattform für das digitale Modell 50 verwendet und Daten aus einem Projekt des CAE-Systems ist das Abbild 50 transferiert. Dazu wurden Funktionen eingebaut, die bei dem Erzeugen einer Revision eine entsprechende Ausleitung bewirken, Die Ausleitung selber ist konfigurierbar gehalten. Da die Struktur des zugrundeliegenden Systems erhalten bleibt, genügte es in den betrachteten Fällen eine Information bei den Objekten und Relationen des CAE-Systems zu hinterlegen, ob diese für das digitale Abbild 50 relevant sind oder nicht. Die nachfolgenden Bilder verdeutlichen dies am Beispiel eines Rohrleitungs- und Instrumentierungsdiagramms.

Das linke Fenster 60 zeigt das Mapping der CAE-Daten A und B der Ergebnisdaten 26 auf die Daten A' und B' des Modells 50. Generell kann das Engineering-Ergebnis nicht mehr Informationen haben als das Engineering selber aufweist, es gibt aber eine Reihe von Vereinfachungen. Beispielsweise werden für das Engineering Strukturen zur Ablage geführt, die nicht kennzeichnungsbildend sind. Diese erscheinen dann ebenfalls nicht in dem Rohrleitungs- und Instrumentierungsdiagramms und entfallen im digitalen Abbild. Das Engineeringsystem 14 muss ferner eine umfangreiche Bibliothek mit den zu verwendenden Komponenten führen. Das Abbild 50, hingegen, weist aber nur die Elemente auf, die tatsächlich verwendet werden. Die Elemente selber können ebenfalls vereinfacht werden. Beispielsweise muss im obigen Beispiel das CAE-System unterschiedliche Typen für Behälter 62 führen, wenn sich die grafische Repräsentation ändert (obwohl die Attributierung identisch ist). Das CAE-System muss dazu unterschiedliche Stammobjekte (Typen) für Behälter mit geraden, konkaven oder konvexen Boden, etc. führen. Dies ist für das Abbild 50 irrelevant, da die Zeichnung fertig übernommen wird und die Attributierung identisch ist. Prinzipiell benötigt das Abbild überhaupt kein Typ-Instanzkonzept. Vorliegend setzte das vorliegende CAE-System eine solche Struktur voraus, so dass dies im Demonstrator 58 nicht umgesetzt werden konnte. Das Beispiel zeigt aber, dass die Bibliotheksinformationen, in der das Know-How der Anlagenbauer steckt, im Abbild 50 so nicht verwendet werden muss und dadurch auch ein Know-How-Schutz erfolgt. Die einzige Zusatzinformation, die benötigt wird, ist eine Strukturierung der Ablage des Abbildes 50. Dazu sind bei der Konfiguration der Ausleitung - neben der Angabe des Zielabbildes selber - Strukturknoten als Ziele anzugeben.

In einem nachfolgenden Schritt sind die so übernommenen Daten mit Daten anderer Engineeringsysteme zu verlinken. Dazu sind zwei Schritte notwendig. In einem Konfigurationsfile wird angegeben. welche Arten von Relationen zwischen den Applikationen entstehen sollen (inklusive Angaben wie 1-1, 1-n Relationen, etc.) und in einem zweiten Schritt auf welcher Grundlage Links zwischen den zugehörigen Instanzen aufzubauen sind. Dadurch, dass die Daten des Abbilds 50 in einer einheitlichen Form vorliegen, können auch einheitliche Redlining Funktionen angeboten werden. Da darüber hinaus ein Herkunftsnachweis geführt wird, sind solche Änderungen der jeweiligen Zielapplikation übergebbar. Auf Basis des eingangs gezeigten Viewers gemäß FIG 2 können Attributänderungen (wenngleich ohne semantische Prüfungen) erfasst werden. Der geänderte Wert kann beispielsweise rot markiert werden. Die so geänderten Daten und Zeichnungen werden dann in das Abbild 50 transferiert und von dort aus anhand des Herkunftsnachweises der jeweiligen Applikation übergeben. Vorteil des Verfahrens ist u.a., dass über das Abbild 50 derartige Änderungen über das Versionsmanagement einheitlich erfasst werden.

FIG 4 zeigt ein in einem Demonstrator 64 realisiertes Beispiel für die Verwendung eines solchen Systems. Ausgehend von einer 3D-Zeichnung 66 wird zu dem zugehörigen Rohrleitungs- und Instrumentierungsplan 68 verzweigt und von dort aus zu dem zugehörigen Funktionscode in der Steuerung 70. Ausgehend von dem Abbild 50 kann über den Herkunftsnachweis (Pfeil 72) das Engineeringwerkzeug gestartet und die zugehörige Ergebnisdatei 72 (hier in Form eines CFCs) angezeigt werden. Ferner kann von dem Funktionscode im Abbild die zugehörige Speichereinrichtung 74 bzw. CPU gefunden werden und über deren Bestellnummer direkt das Service- und Wartungsportal 76 geöffnet werden.

In der Vergangenheit wurde mehrfach versucht, sogenannte Common Information Modelle aufzubauen, die einheitliche Zugriffe auf Engineeringdaten zur Verfügung stellen sollten. Das vorliegende Modell unterscheidet sich von klassischen Ansätzen durch folgende Merkmale:
1. Es ist kein separater Export manuell anzustoßen, um aus Engineeringsystemen 14, 16, 18, 20, 22, 24 ein derartiges Modell 50 zu erzeugen. Der Aufbau erfolgt implizit bei Freigabeverfahren im Engineering.
2. Es werden keine komplexen Abzüge von Engineeringdaten verwendet, sondern ausschließlich Ergebnisdaten 26, 28, 30, 32, 34, 36. Die Übernahme der Daten erfolgt strukturiert entsprechend der Feigabeverfahren im Engineering bzw. der Erstellung der Dokumentation der Anlage 12. Das Modell 50 baut sich sukzessive entsprechend dem Projektfortschritt auf.
3. Die Verlinkung der Ergebnisdaten 26, 28, 30, 32, 34, 36 der Engineeringsysteme 14, 16, 18, 20, 22, 24 erfolgt generisch. Es können für die Projekte Regeln definiert werden, die anhand der Kennzeichnung die Daten verbinden
4. Das Modell 50 verwendet die Strukturen, die die zugrundeliegenden Engineeringsysteme 14, 16, 18, 20, 22, 24 haben, so z. B. die Anlagenstruktur eines CAE-Werkzeugs und technologischen (funktionale) Hierarchien aus den Automatisierungswerkzeugen. Es liegt zwar ein gemeinsames Metamodell vor, dies dient aber dazu, einheitliche Zugriffe auf Daten und Relationen zu ermöglichen. Dies ist ein wesentliches Prinzip, da nur so über einen Herkunftsnachweis ein Bezug zu den zugrundeliegenden Werkzeugen führbar ist und damit Änderungen vor Ort an der Anlage 12 auf eine einfache Art und Weise in die Werkzeuge übernommen werden können.
5. Ergebnisdaten 26, 28, 30, 32, 34, 36 wie z.B. R&I-Diagramme oder Stromlaufpläne weisen einen relativ hohen Standardisierungsgrad im Vergleich zu der Datenhaltung der Applikationen selber auf. Wenn im Freigabeverfahren nur die Daten dieser Reports verwendet werden, wird dadurch ebenfalls eine gewisse Standardisierung erreicht, auch wenn grundlegende Strukturelemente einer Quellapplikation zugrunde liegen. Durch das Vorgehen, nur diese revisionierte Dokumente mit den zugehörigen Daten als Grundlage zu nehmen, ist das System offen, auch Daten von Fremdapplikationen einzubinden, vorausgesetzt, das System lasst eine entsprechende Ausleitung von revisionierten Dokumenten zu. Dies ist ein ganz wesentlicher Aspekt des Vorgehens.
6. Über Herkunftsnachweise können Daten des Abbildes 50 mit den Daten der Engineeringsysteme 14, 16, 18, 20, 22, 24 abgeglichen und somit aktuell und konsistent gehalten werden.
7. Das Abbild 50 stellt kein Abbild der Engineeringsysteme 14, 16, 18, 20, 22, 24 dar, sondern ist für die Betriebsführung von Anlagen 12 optimiert. Es ermöglicht es, Anlagendokumente mit Prozessdaten zu verbinden und Diagnoseprogramme aufzusetzen (z.B. können Druckluftleitungen traversiert werden, um über Meldungen der angeschlossenen Verbraucher und Erzeuger Leckagen zu erkennen und örtlich einzugrenzen).
8. Ein ganz wesentlicher Aspekt des Vorgehens ist der, das diese Form der Integration risikoarm und sukzessive erfolgen kann. Es werden nur Engineeringergebnisse betrachtet, die eine Abstraktionsschicht bezüglich der Datenhaltung der Engineeringwerkzeuge darstellen (z. B. implizit durch Reports oder Exportstrukturen realisiert). Die interne Datenhaltung der Werkzeuge muss nicht geändert werden, es werden nur "Views" auf diese Datenhaltung verwendet. Allerdings ist es notwendig, dass diese Ergebnisse untereinander abgestimmt werden. Dies kann aber in Schritten erfolgen, indem nach und nach Ergebnisse von Werkzeugen hinzugenommen werden. Diese Abstimmung ist eine Grundvoraussetzung, wenn Engineeringwerkzeuge durchgängig gestaltet werden sollen.
9. Die Erzeugung des Abbilds stellt gleichzeitig eine Art der Qualitätskontrolle bezüglich des Zusammenspiels der Ergebnisdaten dar. Engineeringapplikationen können nur die Daten konsistent halten, die sie selber verwalten. Fehlende applikationsübergreifende Referenzen können hingegen nicht erkannt werden. Dies würde aber beim Aufbau des Abbildes gemeldet werden.
10. Ist ein solches Modell etabliert und weist Features wie eine Versionsführung oder gewerkeübergreifende Selektionen auf, werden die Engineeringwerkzeuge - obwohl sie eigenständige Entwicklungen bleiben - über kurz oder lang bzgl. dieser gemeinsamen Features zusammenwachsen. Dies erfolgt aufgrund des Marktdrucks implizit.

### Bezugszeichenliste

- 10: Vorrichtung
- 12: Anlage
- 14, 16, 18: Engineeringsystem
- 20, 22, 24: Engineeringsystem
- 26, 28, 30: Ergebnisdaten
- 32, 34, 36: Ergebnisdaten
- 40: Empfangseinrichtung
- 42: Recheneinrichtung
- 44: Komponente
- 46, 48: Schnittstelle
- 50: Modell
- 52, 54, 56: Fenster
- 58, 60: Fenster
- 62: Behälter
- 64: Demonstrator
- 66: Zeichnung
- 68: Instrumentierungsplan
- 70: Steuerung
- 72: Ergebnisdatei
- 74: Speichereinrichtung
- 76: Service- und Wartungsportal
- A, A': Daten
- B, B': Daten

## Patentansprüche

1. Verfahren zum Überwachen einer Prozess- und/oder Fertigungsanlage (12), die eine Mehrzahl von Komponenten (44) umfasst und die mittels einer Mehrzahl von Engineeringsystemen (14, 16, 18, 20, 22, 24) geplant wird, wobei die Engineeringsysteme durch Engineering-Applikationen, insbesondere durch Computer-Aided-Engineering Applikationen, bereitgestellt werden, und wobei die Engineering-Applikationen unterschiedliche Werkzeuge zum Planen und Erstellen der Prozess- und/oder Fertigungsanlage bereitstellen, mit den Schritten:
a) Bereitstellen von ersten Ergebnisdaten (26) zu zumindest einem Teil der Komponenten (44) von einem ersten der Engineeringsysteme (14), wobei die ersten Ergebnisdaten ein Abbild des aktuellen Planungsstandes des Engineeringprozesses des ersten Engineeringsystem darstellen und in einer ersten Exportstruktur zur Verfügung gestellt werden,
b) Bereitstellen von zweiten Ergebnisdaten (28) zu zumindest einem Teil der Komponenten (44) von einem zweiten der Engineeringsysteme (16), wobei die zweiten Ergebnisdaten ein Abbild des aktuellen Planungsstandes des Engineeringprozesses des zweiten Engineeringsystem darstellen und in einer zweiten Exportstruktur zur Verfügung gestellt werden, und
c) wobei die ersten und zweiten Ergebnisdaten entsprechend der Reihenfolge des Engineeringprozesses entstehen,
d) aus den ersten und zweiten Ergebnisdaten (26, 28) Extrahieren von Topologiedaten, die eine Anordnung der Komponenten (44) innerhalb der Prozess- und/oder Automatisierungsanlage (12) beschreiben, und Betriebsdaten der Komponenten (44), und
e) Erstellen eines Modells (50) für die Prozess- und/oder Fertigungsanlage (12) anhand der Topologiedaten und der Betriebsdaten dadurch, dass in dem Modell (50) eine Verknüpfung zu den ersten und den zweiten Ergebnisdaten (26, 28) bereitgestellt wird, wobei
f) beim Erzeugen des Modells (50) fehlende applikationsübergreifenden Referenzen gemeldet werden.

2. Verfahren nach Anspruch 1, **dadurch gekennzeichnet, dass** in einer Darstellung des Modells (50) die Anordnung der Komponenten innerhalb der Prozess- und/oder Automatisierungsanlage (12) und die Betriebsdaten zu den jeweiligen Komponenten (44) angezeigt werden.

3. Verfahren nach Anspruch 1 oder 2, **dadurch gekennzeichnet, dass** als die Topologiedaten eine jeweilige eingangsseitige und ausgangseitige Wirkverbindung der Komponenten (44) untereinander extrahiert wird.

4. Verfahren nach einem der vorhergehenden Ansprüche, **dadurch gekennzeichnet, dass** als erste oder zweite Ergebnisdaten (26, 28) von den Engineeringsystemen (14, 16) ein dreidimensionales Modell, ein Rohrleitungsplan und/oder ein Stromführungsplan bereitgestellt werden.

5. Verfahren nach einem der vorhergehenden Ansprüche, **dadurch gekennzeichnet, dass** als erste oder zweite Ergebnisdaten (26, 28) von den Engineeringsystemen (14, 16) Datenblätter und/oder Betriebsparameter der Komponenten (44) bereitgestellt werden.

6. Verfahren nach einem der vorhergehenden Ansprüche, **dadurch gekennzeichnet, dass** die aus den ersten und zweiten Ergebnisdaten (26, 28) extrahierten Topologiedaten und Betriebsdaten in ein vorbestimmtes Datenformat überführt werden.

7. Verfahren nach einem der vorhergehenden Ansprüche, **dadurch gekennzeichnet, dass** den Topologiedaten und Betriebsdaten zusätzlich Herkunftsdaten zugeordnet werden, die beschreiben, ob die Topologiedaten und Betriebsdaten von dem ersten oder dem zweiten Ergebnisdaten (26, 28) extrahiert sind.

8. Verfahren nach einem der vorhergehenden Ansprüche, **dadurch gekennzeichnet, dass** bei einer Änderung der ersten und/oder zweiten Ergebnisdaten (26, 28) das Modell (50) angepasst wird.

9. Verfahren nach Anspruch 8, **dadurch gekennzeichnet, dass** die Änderung der ersten und/oder zweiten Ergebnisdaten (26, 28) in dem Modell (50) angezeigt werden.

## Claims

1. Method for monitoring a process and/or production plant (12) that comprises a plurality of components (44) and that is planned by means of a plurality of engineering systems (14, 16, 18, 20, 22, 24), wherein the engineering systems are provided by engineering applications, in particular by computer-aided engineering applications, and wherein the engineering applications provide different tools for planning and creating the process and/or production plant, having the following steps:
a) provision of first result data (26) pertaining to at least one portion of the components (44) by a first of the engineering systems (14), wherein the first result data are a map of the present planning level of the engineering process of the first engineering system and are made available in a first export structure,
b) provision of second result data (28) pertaining to at least one portion of the components (44) by a second of the engineering systems (16), wherein the second result data are a map of the present planning level of the engineering process of the second engineering system and are made available in a second export structure, and
c) wherein the first and second result data arise in accordance with the order of the engineering process,
d) extraction of topology data, which describe an arrangement of the components (44) within the process and/or automation plant (12), and operating data for the components (44) from the first and second result data (26, 28), and
e) creation of a model (50) for the process and/or production plant (12) on the basis of the topology data and the operating data by virtue of a link to the first and second result data (26, 28) being provided in the model (50), wherein
f) missing cross-application references are reported during production of the model (50).

2. Method according to Claim 1, **characterized in that** the arrangement of the components within the process and/or automation plant (12) and the operating data pertaining to the respective components (44) are displayed in a representation of the model (50).

3. Method according to Claim 1 or 2, **characterized in that** the topology data extracted are a respective input-side and output-side operative connection of the components (44) among one another.

4. Method according to one of the preceding claims, **characterized in that** the first or second result data (26, 28) provided by the engineering systems (14, 16) are a three-dimensional model, a pipeline plan and/or a conduction plan.

5. Method according to one of the preceding claims, **characterized in that** the first or second result data (26, 28) provided by the engineering systems (14, 16) are data sheets and/or operating parameters for the components (44).

6. Method according to one of the preceding claims, **characterized in that** the topology data and operating data extracted from the first and second result data (26, 28) are converted into a predetermined data format.

7. Method according to one of the preceding claims, **characterized in that** the topology data and operating data are additionally attributed origin data that describe whether the topology data and operating data are extracted from the first or the second result data (26, 28).

8. Method according to one of the preceding claims, **characterized in that** the model (50) is adjusted in the event of a change in the first and/or second result data (26, 28).

9. Method according to Claim 8, **characterized in that** the change in the first and/or second result data (26, 28) is indicated in the model (50).

## Revendications

1. Procédé de surveillance d'une installation de processus et/ou de fabrication (12) qui comprend une pluralité de composants (44) et qui est planifiée au moyen d'une pluralité de systèmes d'ingénierie (14, 16, 18, 20, 22, 24),
les systèmes d'ingénierie étant fournis par des applications d'ingénierie, et plus particulièrement par des applications d'ingénierie assistées par ordinateur, et les applications d'ingénierie fournissant différents outils pour planifier et créer l'installation de processus et/ou de fabrication, comportant les étapes suivantes :
a) fourniture de premières données de résultat (26) relatives à au moins une partie des composants (44) par un premier des systèmes d'ingénierie (14), les premières données de résultat étant une image de l'état de planification actuel du processus d'ingénierie du premier système d'ingénierie et étant mises à disposition dans une première structure d'exportation,
b) fourniture de deuxièmes données de résultat (28) relatives à au moins une partie des composants (44) par un deuxième des systèmes d'ingénierie (16), les deuxièmes données de résultat étant une image de l'état de planification actuel du processus d'ingénierie du deuxième système d'ingénierie et étant mises à disposition dans une deuxième structure d'exportation, et
c) les premières et deuxièmes données de résultat naissant dans l'ordre du processus d'ingénierie,
d) à partir des premières et deuxièmes données de résultat (26, 28), extraction de données topologiques, qui décrivent un agencement des composants (44) au sein de l'installation de processus et/ou d'automatisation (12), et de données opérationnelles des composants (44), et
e) création d'un modèle (50) pour l'installation de processus et/ou de fabrication (12) à l'aide des données topologiques et des données opérationnelles par fourniture, dans le modèle (50), d'une association aux premières et aux deuxièmes données de résultat (26, 28),
f) des références interapplications manquantes étant signalées lors de la création du modèle (50).

2. Procédé selon la revendication 1, **caractérisé en ce que** sont indiqués, dans une représentation du modèle (50), l'agencement des composants au sein de l'installation de processus et/ou d'automatisation (12) et les données opérationnelles relatives aux composants respectifs (44).

3. Procédé selon la revendication 1 ou 2, **caractérisé en ce qu'**est extraite, en tant que données topologiques, une liaison active respective, côté entrée et côté sortie, des composants (44) entre eux.

4. Procédé selon l'une des revendications précédentes, **caractérisé en ce que** sont fournis par les systèmes d'ingénierie (14, 16), en tant que premières et deuxièmes données de résultat (26, 28), un modèle tridimensionnel, un plan de tuyauterie et/ou un plan d'alimentation électrique.

5. Procédé selon l'une des revendications précédentes, **caractérisé en ce que** sont fournis par les systèmes d'ingénierie (14, 16), en tant que premières ou deuxièmes données de résultat (26, 28), des fiches de données et/ou des paramètres opérationnels des composants (44).

6. Procédé selon l'une des revendications précédentes, **caractérisé en ce que** les données topologiques et les données opérationnelles extraites des premières et des deuxièmes données de résultat (26, 28) sont converties dans un format de données prédéterminé.

7. Procédé selon l'une des revendications précédentes, **caractérisé en ce que** sont additionnellement associées aux données topologiques et aux données opérationnelles des données d'origine qui décrivent si les données topologiques et les données opérationnelles sont extraites des premières ou des deuxièmes données de résultat (26, 28).

8. Procédé selon l'une des revendications précédentes, **caractérisé en ce que** le modèle (50) est adapté en cas de modification des premières et/ou des deuxièmes données de résultat (26, 28).

9. Procédé selon la revendication 8, **caractérisé en ce que** la modification des premières et/ou des deuxièmes données de résultat (26, 28) est indiquée dans le modèle (50).
